(19) Europäisches Patentamt
European Patent Office
Office européen des brevets

(11) **EP 2 012 342 A2**

(12) **EUROPEAN PATENT APPLICATION**

(43) Date of publication:
**07.01.2009 Bulletin 2009/02**

(51) Int Cl.:
**H01J 37/32** (2006.01)

(21) Application number: **08252118.8**

(22) Date of filing: **19.06.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **26.06.2007 US 749069**

(71) Applicant: **INTEVAC, INC.**
**Santa Clara,**
**California 95054 (US)**

(72) Inventors:
• **Yang, Jang Gyoo**
**San Jose**
**CA, 95138 (US)**

• **Barnes, Michael**
**San Ramon**
**CA, 94583 (US)**
• **Bluck, Terry**
**Sanza Clara**
**CA, 95051 (US)**

(74) Representative: **Foster, Mark Charles et al**
**Mathisen, Macara & Co.**
**The Coach House**
**6-8 Swakeleys Road**
**Ickenham, Uxbridge UB10 8BZ (GB)**

(54) **Hybrid etch chamber with decoupled plasma controls**

(57) A dielectric etch chamber and method for improved control of plasma parameters. The plasma chamber 100 comprises dual-frequency bias source that capacitively couples the RF energy to the plasma, and a single or dual frequency source that inductively couples the RF energy to the plasma. The inductive source may be modulated for improved etch uniformity.

*Figure 1*

**Description**

**BACKGROUND**

1. Field of the Invention

The subject invention relates to an etch chamber having independent control of plasma parameters.

2. Related Art

Plasma etch chambers have been used in the semiconductor art for years. In general, plasma etch chambers can be divided into types by application and by plasma source. With respect to application, plasma chambers are divided into conductor etchers, those that are used to etch polysilicon and metals, and dielectric etchers, those that are used for etching insulators, such as silicon oxide, undoped silicate glass (USG), boron-phosphorous silicate glass (BPSG), etc. As for plasma sources, the two main types relating to the subject application are capacitively coupled and inductively coupled chambers. As is well known, a capacitively coupled chamber is constructed using a cathode and an anode and applying an RF potential there-between. On the other hand, in inductively coupled chambers the RF energy is coupled into the chamber by an antenna situated above or around the chamber.

Inductively coupled chambers have been used mostly for conductor etch applications, due their ability to generate high density plasma and, thereby, high etch rates. On the other hand, capacitively coupled chambers have been used mostly in dielectric etch applications, due to their ability to provide improved selectivity, although these chambers generally produce low to medium density plasma, and thereby lower etch rates.

Inductively-coupled plasma sources have been previously used in the art for some dielectric etch applications, however, various solutions had to be developed to resolve issues raised by the high density plasma generated. That is, inductively-coupled plasma chambers tend to break the precursor gas molecules into small constituencies. The abundance of small ions, such as fluorine, adversely effect the plasma etch process. To reduce the amount of fluorine, it has been proposed to use a heated silicon part inside the chamber to act as a fluorine scavenging agent. Another proposal was to pulse or modulate the RF energy of the antenna.

Regardless of the plasma source used, there has been a continuous quest in the art to enable independent control of plasma parameters. For example, in inductively-coupled chambers one RF frequency is applied to an antenna to generate the plasma and control ion density and one RF bias frequency is applied to a cathode to control ion energy bombardment. In this manner, the energy applied to the antenna can be used to control plasma density, while the energy applied to the cathode can be used to control ion energy. In order to enable similar capability in capacitively-coupled chambers, dual-frequency capacitively coupled chambers have been developed. In such chambers, high frequency RF energy is used to control plasma density, while low frequency RF energy is used to control ion energy.

Recent development in semiconductor technology has imposed increased requirement on dielectric etch capabilities. These requirements necessitate better and independent control of various plasma parameters. To meet these requirements it has recently been proposed to use multiple frequencies in a capacitively-coupled chamber for dielectric etch. Notably, it has been proposed to use two different high frequency RF energies to control plasma dissociation and a lower frequency to control ion energy.

Further information regarding the above prior art issues can be found in, for example, U.S. patents 6,589,437; 7,144,521, and U.S. published applications 2005/0264218 and 2005/0133163. However, in spite of all of the proposed solutions, there is still a need for an improved etch chamber that enables better and independent control of plasma parameters. Some of the issues facing current etch chamber technology includes inability to independently control gas dissociation, inability to obtain high selectivity with high etch rate, difficulty in performing plasma chamber clean process due to insufficient plasma density, inability to operate at low pressure, e.g., lower than 10 mTorr, and high erosion rate of chamber parts, such as showerhead.

**SUMMARY**

The present invention is defined in the independent claims.

The following summary of the invention is provided in order to provide a basic understanding of some aspects and features of the invention. This summary is not an extensive overview of the invention and as such it is not intended to particularly identify key or critical elements of the invention or to delineate the scope of the invention. Its sole purpose is to present some concepts of the invention in a simplified form as a prelude to the more detailed description that is presented below.

Various aspects of the subject invention provide an improved control of plasma etching by providing different control of the various parameters effecting the plasma. To achieve the improved control the neutrals flux is controlled using an inductively coupled plasma source, the physical sputtering yield and the ion enhanced etching yield is controlled by one capacitively coupled source; while the ion flux is controlled by another capacitively coupled source of higher frequency than the first capacitively coupled source.

According to other aspects of the invention, an etch plasma processing chamber for etching a substrate having a dielectric layer thereupon is provided, comprising:

a) a reactor vessel comprising non-conducting lateral wall, a ceiling, and a bottom closure comprising a wafer support device, said ceiling and said wafer support device defining a parallel plate reactor;

b) a first RF power source providing RF energy to the support device at a frequency $\omega_{pd}$ sufficient to initiate and maintain a plasma of a process gas;

c) a second RF power source providing RF energy to the support device at a frequency $\omega_{ion}$ sufficient to control kinematical properties of ions generated in the plasma, wherein $\omega_{ion} < \omega_{pd}$;

d) inductive windings situated about the non-conductive lateral wall of said reactor vessel; and,

e) a third RF power source providing RF energy to the inductive windings to inductively couple said third RF power source to said plasma.

The third RF power source may provide RF energy to the inductive windings at frequency $\omega_{icp} < \omega_{ion}$. The etch plasma processing chamber may further comprise modulating apparatus to modulate the third RF power to thereby output pulses having selectable amplitude, width, and inter-pulse interval. The inductive windings may be distributed axially about said lateral wall.

The inductive windings may comprise a first coil and a second coil. The third RF power source may comprise a first power supply coupling power to the first coil and a second power supply coupling power to the second coil. The frequencies of the first power supply and the second power supply may be below 2MHz, and the frequency of one of the first and second power supplies may be about half that of the other. The frequencies of the first power supply and the second power supply may be below 2MHz, and the frequencies of the first power supply and the second power supply may be the same. The lateral wall may comprise a vertical section and a horizontal section, and the first coil may be wound in a vertical direction about the vertical section, and the second coil may be wound in a horizontal direction about the horizontal section. The first RF power source may provide RF energy at a frequency above 10MHz, the second RF power source may provide RF energy at a frequency below 10MHz, and the third RF power source may provide RF energy at a frequency below 2MHz. The first RF power source may provide RF energy at a frequency above 15MHz, the second RF power source may provide RF energy at a frequency below 15MHz, and the third RF power source may provide RF energy at a frequency below 2MHz. The etch first RF power source may provide RF energy at a frequency of about 60MHz, the second RF power source may provide RF energy at a frequency of about 2MHz, and the third RF power source may provide RF energy at a frequency not exceeding 1MHz. The etch plasma processing chamber may further comprise a baffle preventing plasma from entering an exhaust manifold. The etch plasma processing chamber may further comprise a switching circuit coupled between the third RF power source and the first and second coils. The switching circuit may control power ratio of the RF power applied from the third RF power source to the first coil and the second coil.

According to other aspects of the invention, a method of operating a plasma reactor is provided, comprising:

a. introducing a workpiece into the reactor;

b. introducing a process gas into the reactor,

c. capacitively coupling high frequency RF energy into the reactor so as to initiate and maintain a process plasma within the reactor;

d. capacitively coupling low frequency RF energy into the reactor so as to control ion energy of ions within the plasma; and,

e. inductively coupling RF energy into the reactor so to control neutrals flux within the plasma.

The method may further comprise modulating the second low frequency RF energy to generate modulated inductive coupling. The process of inductively coupling second low frequency RF energy may comprise energizing a first coil at a first frequency and energizing a second coil at a second frequency. The first frequency may be about half of the second frequency. The frequencies of the first frequency and the second frequency may be about the same. The method may further comprise:

f. removing the workpiece from the reactor; and,

g. inductively coupling the second low frequency RF energy into the reactor so to ignite plasma to clean the reactor from residue.

Step e may comprise modulating the low frequency RF energy to generate modulated inductive coupling. The power level at step g may be higher than power level at step e.

## BRIEF DESCRIPTION OF THE DRAWINGS

The accompanying drawings, which are incorporated in and constitute a part of this specification, exemplify the embodiments of the present invention and together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.

Figure 1 is a schematic cross-section of an etch chamber according to an embodiment of the invention.

Figure 2 is a schematic illustration of a flow chart of a process according to an embodiment of the invention.

Figure 3 is a schematic cross section of another embodiment of the invention.

Figure 4 is a schematic cross section of yet another embodiment of the invention.

## DETAILED DESCRIPTION OF EMBODIMENTS

The embodiments provide an etch chamber that enables advance etch processes by enabling independent control of gas dissociation, plasma density, and ion energy. The current inventors have discovered that an improved control of plasma processing parameters can be obtained by combining an inductive-coupling antenna driven at one frequency with dual frequency bias RF power. Moreover, the subject inventors have discovered that the improved control is further enhanced by having the power to the antenna modulated.

Equation 1 estimates the relationship of the etch rate to the various elements of the plasma.

Eq. 1:

$$ER_{gross} = k_0 \Gamma \exp(-\frac{Ea}{kT}) + Y_p(1-\Theta)\Gamma_+ + Y_{IE}\Theta\Gamma_+$$

Wherein - $k_0$ and $Ea$ are rate parameters for spontaneous chemical etching; $\Gamma$ is the neutrals flux; $Yp$ is the physical sputtering yield; $\Theta$ is the fraction of surface sites occupied by the reactant species; $\Gamma_+$ is the Ion flux; and $Y_{IE}$

is the ion enhanced etching yield while the surface is saturated with reactant species. The first term, i.e., $k_0 \Gamma \exp(-\frac{Ea}{kT})$

is the most dominant term for chemical etching and for chamber cleaning; the second term, i.e., $Y_p(1-\Theta)\Gamma_+$ is the dominant term for physical etching, i.e., ion bombardment; and the last term, i.e., $Y_{IE}\Theta\Gamma_+$ is the dominant term for ion enhanced etching. By understanding this relationship, the present inventors have investigated ways to control the various parameters independently.

Notably, the inventors have determined that an improved control of plasma etching may be obtained by providing different control of the various parameters of Equation 1, to thereby control the relationship of the etch rate to the various elements of the plasma. To achieve the improved control the inventors have determined that a beneficial effect can be obtained by controlling the neutrals flux r using an inductively coupled plasma source. This also controls the fraction of surface sites occupied by the reactant species, i.e., $\Theta$. On the other hand, the physical sputtering yield $Y_p$ and the ion enhanced etching yield, $Y_{1E}$, which are both directly related to the ion energy, should be controlled by one capacitively coupled source; while the ion flux, $\Gamma_+$, should be controlled by another capacitively coupled source of higher frequency than the first capacitively coupled source.

By designing a plasma chamber according to the guidelines provided above, the first term of Equation 1, i.e., chemical etching and chamber cleaning, is controlled by the power applied to the inductively coupled source. The second term, i.e., the ion energy for etching is controlled by the power applied to the low frequency capacitively coupled source. The third term, i.e., the ion flux enhancement term, is controlled by a combination of the power applied to the inductive source, the low frequency source, and the high frequency source.

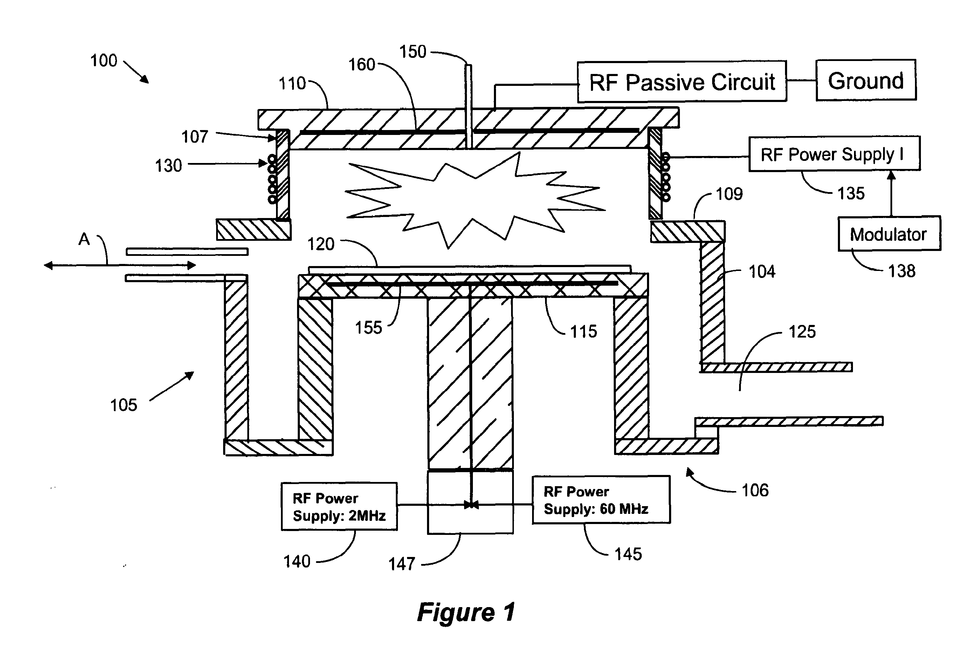

Figure 1 is a schematic cross-section of an etch chamber 100 according to an embodiment of the invention.

Chamber 100 comprises the upper chamber body 107, which is generally in a circular shape and of a material which permits coupling of RF energy therethrough. Chamber 100 further comprises lower chamber body, 105, which is conductive and comprises vertical wall 104, horizontal part 109, and bottom 106. The lower chamber body 105, the upper chamber body 107 and ceiling 110 together form a vacuum chamber. The vertical wall 104 and horizontal part 109 forms a conductive lateral wall of the chamber. The upper chamber body 107 forms a non-conductive lateral wall of the chamber and is fitted with a ceiling 110, which may be conductive or include a conductive electrode 160 opposing the cathode 115. The ceiling may also include gas injection provision 150 for injecting precursor gas into the chamber. The injection provision 150 may be a single injector, multiple injectors, a showerhead, etc., as is known in the art. The cathode 115 may be any conventional cathode and generally comprises an embedded electrode plate 155, which is used to chuck the wafer 120 by application of a DC bias, and for capacitively coupling RF energy in cooperation with the opposing electrode 160 of the ceiling 110. The chamber 100 is evacuated via evacuation manifold 125.

A coil 130 is provided about the upper chamber wall 107 and is provided with RF energy from RF power supplier 135. In this embodiment, the RF power supply 135 generates low RF frequency, generally below about 2MHz or below 1MHZ. In this particular example the power supply 135 generates RF frequency of about 600-900KHZ. Chamber 100 is further energized from the cathode 115 using two RF power suppliers 140 and 145. When applying RF frequency to the cathode 115, the ceiling 110 acts as an opposing ground to enable capacitive coupling of RF energy to the plasma. In this embodiment the RF power supplier 140 generates RF frequency of below 10MHz, while the RF power supplier 145 generate RF frequency above 10MHz. In this particular example, power supplier 140 generates RF power at 2MHz while power supplier 145 generates RF frequency at higher frequency, e.g., 27MHz or 60MHz.

In operating the chamber of Figure 1, the inductive coil 130 may be powered by power supplier 135 continuously or with pulsed power. When energizing the coil 130 with pulsed power, it is advantageous to use an "instant on" power supplier, such as that disclosed in, for example, U.S. patent 7,100,532, to Pribyl, the entire disclosure of which is incorporated herein by reference.

The power applied to the coil 130 from the power supplier 135 may be at about 100W-2000W for processing and about 1kW-5kW for plasma chamber cleaning. In an embodiment where power supplier 135 is a "switched" or "pulsed" power supplier, it produces a sinusoidal waveform on the order of 600 to 900 kHz (in continuous duty) and is subject to a modulator 138 to control the width, amplitude and interpulse delay, or duty cycle, of any individual pulse or train of pulses. The desired modulation can be obtained by simple operations on the switching control portion of the power supplier 135 to realize the desired amplitude, width and interpulse interval. The power supplied by the capcitively-coupled low frequency power supplier 140 may be about 0-10kW, while that of the high frequency capcitively-coupled power supplier 145 may be about 0-5kW. The capacitively-coupled RF biases are applied through impedance match and coupler network 147 to the process plasma, through the wafer 120, as is known in the art.

Using the inventive chamber as described above, the inventors were able to achieve improved results not previously obtainable. Notably, the inventors were able to overcome the intrinsic problems of low selectivity of inductively-coupled chambers and low etch rates of capacitively-coupled etch chambers. By using the combination of low frequency inductive source and dual-frequency capacitive source, the inventors were able to achieve high etch rates at high selectivity. Additionally, this arrangement enables high chamber cleaning efficiency by the availability of high-density plasma generated by the inductive source.

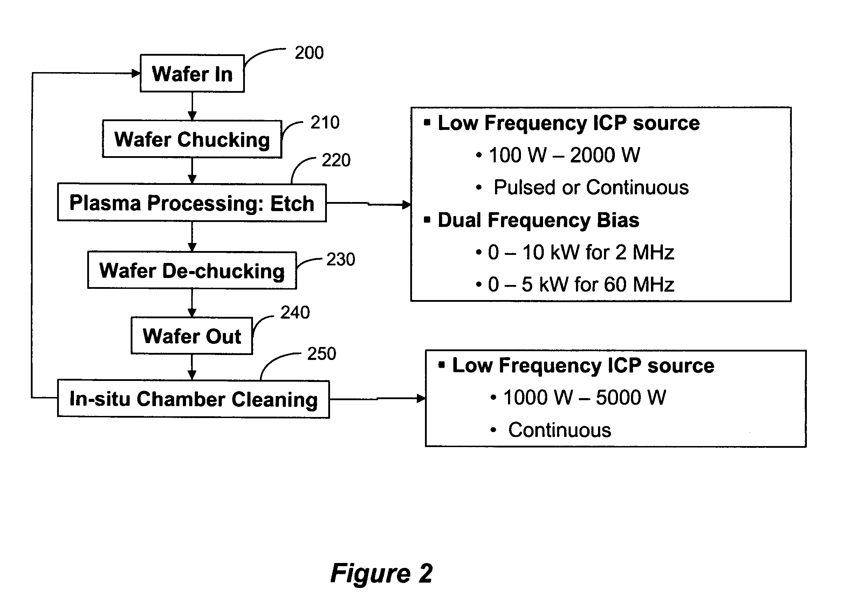

To illustrate some benefits of the design of the inventive chamber, consider the following process cycle. Generally it is known in the art that dielectric etch causes materials, such as polymers, to deposit on the chamber's interior. Such deposits can be detrimental in that they can cause defects in the subsequent substrate that is being processed or cause variation in the plasma process as it effects the plasma chemistry and can change the plasma constituency. Accordingly, the process illustrated in Figure 2 is implemented using the inventive chamber design to eliminate these problems. In Step 200 a substrate to be etched, such as a wafer, is inserted into the chamber via a loading slit, as illustrated by arrow A in Figure 1. At Step 210 the wafer is chucked by applying a chucking potential to the electrode 155 in the presence of plasma. At Step 220 the plasma etch process is carried out by applying a continuous or pulsed RF power to the coil 130. The RF power applied to the coil is at about 100W-2000W. At the same time, dual-frequency RF bias power is applied to the electrode 155 at about 0-10kW at 2MHz and about 0-5kW at 60MHz. When the etch process is completed, at Step 230 the wafer is de-chucked and at Step 240 it is taken out of the chamber. Then at Step 250 plasma is ignited again by applying RF power to the coil 130 in order to clean all residues from the interior of the chamber. However, for the cleaning step the process is adjusted to be mostly chemical and not physical. Therefore, high density plasma is generated by applying about 1kW-5kW RF power to the coil 130. This causes the species of the plasma to dissociate to very small constituencies, such as oxygen radicals, which greatly assist in the chemical etching of residue. Once the cleaning is completed, the process is repeated by inserting the next wafer to be etched.

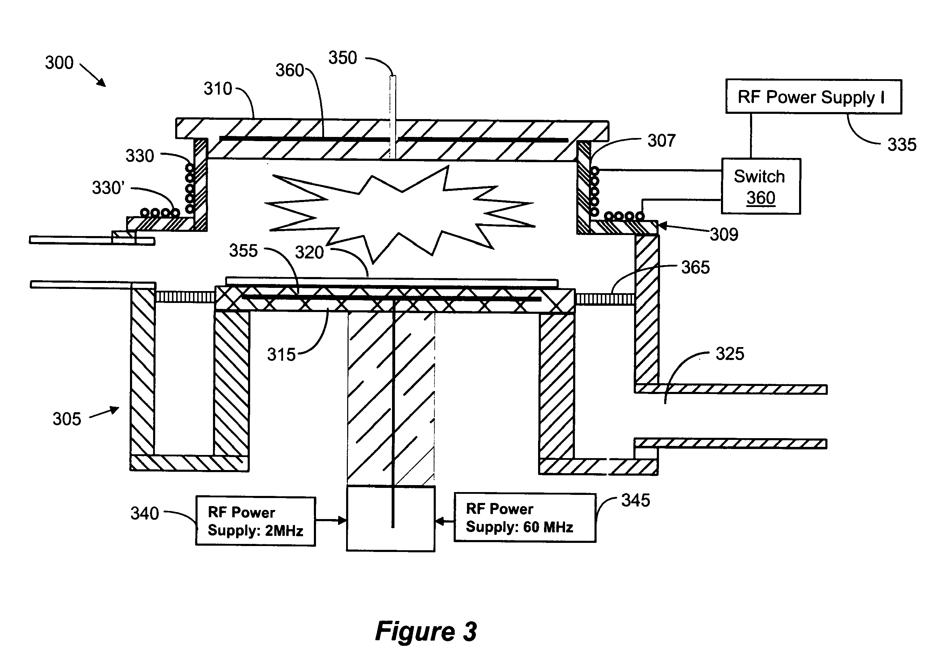

Figure 3 is a schematic cross section of another embodiment of the invention. The chamber 300 of Figure 3 is similar to that of Figure 1, so that only the different features will be discussed herein. Notably, in the chamber of Figure 3 horizontal part, 309, of the lower chamber body, 305, is made of a material transparent to RF energy, so in effect it becomes part of the upper chamber body 307, i.e., both upper chamber body 307 and part 309 form the non-conductive lateral wall about which the RF coil(s) are provided. The chamber of Figure 3 also includes two inductive coils 330 and 330'. In this embodiment the two coils 330 and 330' may be energized selectively by the RF power supplier 335 via switching circuit 360. Switching circuit 360 may apply RF power to each coil in an on/off manner or in a variable power manner using, e.g., a variable coupling circuitry as known in the art. In this manner, improved control of the plasma and the plasma distribution may be achieved. For example, one of the coils may be used during plasma etching while both during plasma chamber cleaning. Incidentally, Figure 3 also illustrates the use of a baffle 365 to prevent plasma from reaching into manifold 325. Baffle 365 may be any known baffle used in the art.

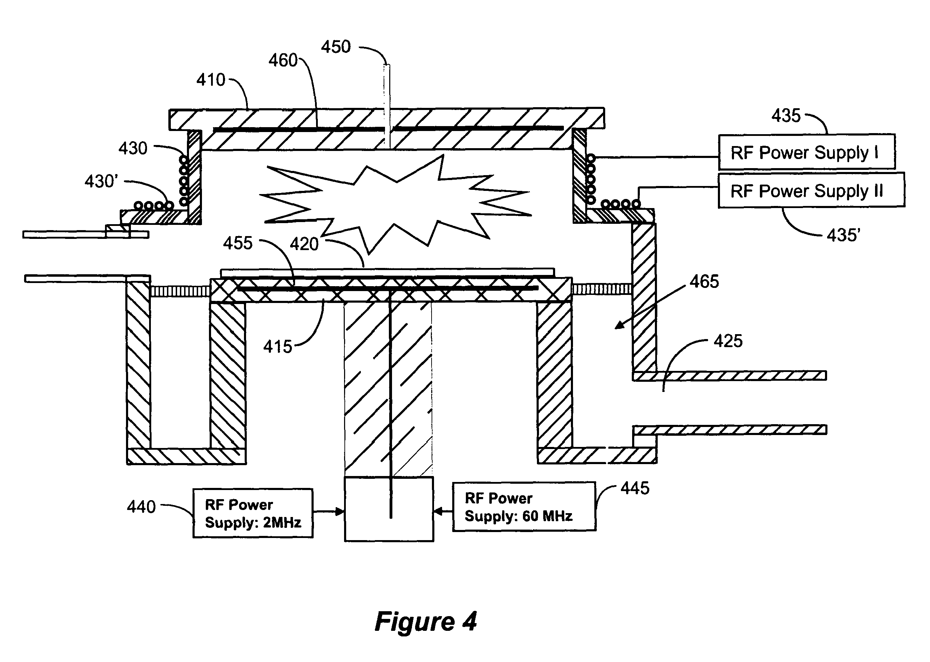

Figure 4 is a schematic cross-section of yet another embodiment of the invention. The chamber of Figure 4 is similar to that of Figure 3, in that two coils 430 and 430' are provided. However, in the embodiment of Figure 4 separate power suppliers 435 and 435' are used to energize the coils. According to one embodiment both power suppliers 435 and 435' operate at the same frequency, e.g. below 1MHz. However, according to another embodiment, the two power suppliers 435 and 435' operate at different frequencies, each below 1MHz. According to one specific example, one power supplier operates at 600KHz while the other at 900KHz.

To summarize, various embodiments of the invention utilize dual-frequency capacitively-coupled plasma bias source in combination with single or dual inductively coupled plasma source. Dual-frequency capacitively-coupled plasma source is energized by a first RF generator operating at a frequency $\omega_i$, selected to transfer energy to ions, and a second RF generator operating at a frequency $\omega_p >> \omega_i$. Both RF frequencies are applied in mutual RF isolation to the semiconductor wafer support, while the ceiling acts as the ground potential. The second RF generator frequency $\omega_p$ is chosen to be large compared to $\omega_i$, i.e., ($\omega_p / \omega_i$) is selected to be greater than about 2 and, in one particular example, is set to be 30. The inductively-coupled excitation contribution is independent of the RF bias frequencies and have no significant effect on the plasma sheath formed close to the wafer surface. The inductively-coupled frequency is set to be lower than $\omega_i$, and is generally selected to be half or lower than half of the bias frequency $\omega_i$.

Utilizing the combination of the higher dual-frequency RF biases applied to the wafer and the provision of a low impedance switching type RF source for the inductive coupling, the inventive chamber provides a stable plasma processing and improved control over the plasma parameters. First, impedance matching of the low impedance source to the low impedance load negates the need for a substantial matching network. Second, the absence of the network for impedance matching means that the load "follows" the waveform of the RF switching source output with great fidelity. In combination with modulation apparatus, the low frequency RF source for inductive coupling is enabled to provide pulse width and/or inter-pulse delay modulation. Excellent reproducibility is achieved between single pulses, inter-pulse delay and pulse width modulation. Selective control of the plasma electron energy distribution through modulation of the inductive coupling is thus achieved, while the plasma density is independently maintained through steady state RF power (high frequency) at (substantially) the selected plasma frequency that is applied as a bias to the wafer. The precise interpulse delay permits relaxation of the plasma electrons to proceed in a controlled manner and the formation of a selected time averaged electron energy distribution provides a means to manipulate the chemistry of the plasma, thereby to emphasize or de-emphasize selected radical formation. The switched inductive-coupling power source is capable of a wide frequency range of approximately +/- 50% (through control of the switching functions) without adjustment of auxiliary circuits.

Finally, it should be understood that processes and techniques described herein are not inherently related to any particular apparatus and may be implemented by any suitable combination of components. Further, various types of general purpose devices may be used in accordance with the teachings described herein. It may also prove advantageous to construct specialized apparatus to perform the method steps described herein. The present invention has been described in relation to particular examples, which are intended in all respects to be illustrative rather than restrictive. Those skilled in the art will appreciate that many different combinations of hardware, software, and firmware will be suitable for practicing the present invention. For example, the described software may be implemented in a wide variety of programming or scripting languages, such as Assembler, C/C++, perl, shell, PHP, Java, etc.

The present invention has been described in relation to particular examples, which are intended in all respects to be illustrative rather than restrictive. Those skilled in the art will appreciate that many different combinations of hardware, software, and firmware will be suitable for practicing the present invention. Moreover, other implementations of the invention will be apparent to those skilled in the art from consideration of the specification and practice of the invention disclosed herein. Various aspects and/or components of the described embodiments may be used singly or in any combination in the plasma chamber arts. It is intended that the specification and examples be considered as exemplary only, with a true scope and spirit of the invention being indicated by the following claims.

**Claims**

1. An etch plasma processing chamber for etching a substrate having a dielectric layer thereupon, comprising

a) a reactor vessel comprising non-conducting lateral wall, a ceiling, and a bottom closure comprising a wafer support device, said ceiling and said wafer support device defining a parallel plate reactor;

b) a first RF power source providing RF energy to the support device at a frequency $\omega_{pd}$ sufficient to initiate and maintain a plasma of a process gas;

c) a second RF power source providing RF energy to the support device at a frequency $\omega_{ion}$ sufficient to control kinematical properties of ions generated in the plasma, wherein $\omega_{ion} < \omega_{pd}$;

d) inductive windings situated about the non-conductive lateral wall of said reactor vessel; and,

e) a third RF power source providing RF energy to the inductive windings to inductively couple said third RF power source to said plasma.

2. The etch plasma processing chamber of claim 1, wherein the third RF power source provides RF energy to the inductive windings at frequency $\omega_{icp} < \omega_{ion}$.

3. The etch plasma processing chamber of claim 1 or 2, further comprising modulating apparatus to modulate the third RF power to thereby output pulses having selectable amplitude, width, and inter-pulse interval.

4. The etch plasma processing chamber of claim 1,2 or 3, wherein said inductive windings are distributed axially about said lateral wall.

5. The etch plasma processing chamber of any one of claims 1 to 4, wherein said inductive windings comprises a first coil and a second coil.

6. The etch plasma processing chamber of claim 5, wherein said third RF power source comprises a first power supply coupling power to the first coil and a second power supply coupling power to the second coil.

7. The etch plasma processing chamber of claim 6, wherein the frequencies of the first power supply and the second power supply are below 2MHz, and wherein the frequency of one of the first and second power supplies is about half that of the other.

8. The etch plasma processing chamber of claim 6 wherein the frequencies of the first power supply and the second power supply are below 2MHz, and wherein the frequencies of the first power supply and the second power supply are the same.

9. The etch plasma processing chamber of claim 5, wherein the lateral wall comprises a vertical section and a horizontal section, and wherein the first coil is wound in a vertical direction about the vertical section, and the second coil is wound in a horizontal direction about the horizontal section.

10. The etch plasma processing chamber of any one of claims 1 to 9, wherein

(a) the first RF power source provides RF energy at a frequency above 10MHz, the second RF power source provides RF energy at a frequency below 10MHz, and the third RF power source provides RF energy at a frequency below 2MHz;

(b) the first RF power source provides RF energy at a frequency above 15MHz, the second RF power source provides RF energy at a frequency below 15MHz, and the third RF power source provides RF energy at a frequency below 2MHz; or

(c) the first RF power source provides RF energy at a frequency of about 60MHz, the second RF power source provides RF energy at a frequency of about 2MHz, and the third RF power source provides RF energy at a frequency not exceeding 1MHz.

11. The etch plasma processing chamber of any one of claims 1 to 10, further comprising a baffle preventing plasma from entering an exhaust manifold.

12. The etch plasma processing chamber of claim 5, further comprising a switching circuit coupled between the third RF power source and the first and second coils, and wherein the switching circuit controls power ratio of the RF power applied from the third RF power source to the first coil and the second coil.

13. A method of operating a plasma reactor, comprising:

a. introducing a workpiece into the reactor;

b. introducing a process gas into the reactor,

c. capacitively coupling high frequency RF energy into the reactor so as to initiate and maintain a process plasma within the reactor;

d. capacitively coupling low frequency RF energy into the reactor so as to control ion energy of ions within the plasma; and,

e. inductively coupling RF energy into the reactor so to control neutrals flux within the plasma.

**14.** The method of claim 13, further comprising modulating the second low frequency RF energy to generate modulated inductive coupling.

**15.** The method of claim 13 or 14, wherein the process of inductively coupling second low frequency RF energy comprises energizing a first coil at a first frequency and energizing a second coil at a second frequency.

**16.** The method of claim 15, wherein the first frequency is about half of the second frequency.

**17.** The method of claim 15, wherein the frequencies of the first frequency and the second frequency are about the same.

**18.** The method of claim 13,14,15,16 or 17, further comprising:

f. removing the workpiece from the reactor; and,

g. inductively coupling the second low frequency RF energy into the reactor so to ignite plasma to clean the reactor from residue.

**19.** The method of claim 18, wherein step e comprises modulating the low frequency RF energy to generate modulated inductive coupling.

**20.** The method of claim 18, wherein power level at step g is higher than power level at step e.

*Figure 1*

Wafer In — 200

Wafer Chucking — 210

Plasma Processing: Etch — 220

- **Low Frequency ICP source**
  - 100 W – 2000 W
  - Pulsed or Continuous
- **Dual Frequency Bias**
  - 0 – 10 kW for 2 MHz
  - 0 – 5 kW for 60 MHz

Wafer De-chucking — 230

Wafer Out — 240

In-situ Chamber Cleaning — 250

- **Low Frequency ICP source**
  - 1000 W – 5000 W
  - Continuous

*Figure 2*

Figure 3

**Figure 4**

EP 2 012 342 A2

**EP 2 012 342 A2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6589437 B
- US 7144521 B
- US 20050264218 A
- US 20050133163 A
- US 7100532 B